# EUROPEAN PATENT APPLICATION

(11) **EP 4 636 796 A1**
(43) Date of publication of application: **22.10.2025**
(21) Application number: 24199908.5
(22) Date of filing: 12.09.2024
(51) Int. Cl.: H01G 4/012, H01G 4/33, H10D 1/60, H01G 4/232, H01G 4/38, H10D 1/68, H01L 23/522

(54) **VIA BARS INTERLEAVED WITH CAPACITOR STRUCTURE**

(30) Priority: 18.04.2024 US 202418639641
(71) Applicant: GLOBALFOUNDRIES Singapore Pte. Ltd., Singapore 738406 (SG)
(72) Inventor: KHOR, Ee Jan, 738406 Singapore (SG); YI, Wanbing, 738406 Singapore (SG)
(74) Representative: Lambacher, Michael

(57) **Abstract**

The present disclosure relates to semiconductor structures and, more particularly, to via bars interleaved between conductive plates of a capacitor structure and methods of manufacture. The structure includes: a capacitor structure having a plurality of capacitor plates within layers of dielectric material; a wiring structure in a lower layer of the dielectric material, the wiring structure electrically connecting to one of the capacitor plates; and a plurality of via bars within the layers of dielectric material and interleaved with the plurality of capacitor plates. The plurality of via bars have a different width dimension than the plurality of capacitor plates.

## Description

### BACKGROUND

The present disclosure relates to semiconductor structures and, more particularly, to via bars interleaved between conductive plates of a capacitor structure and methods of manufacture.

Capacitors are widely used as parts of electrical circuits in many common electrical devices. For example, capacitors can be used in semiconductor devices in applications such as electronic filters, analog-to-digital converters, memory devices, control applications, etc. The capacitance, or the amount of charge held by the capacitor per applied voltage, depends on a number of parameters, such as the area of the plates, the distance between the plates, and the dielectric constant value of the insulating material between the plates, as examples.

### SUMMARY

In an aspect of the disclosure, a structure comprises: a capacitor structure comprising a plurality of capacitor plates within layers of dielectric material; a wiring structure in a lower layer of the dielectric material, the wiring structure electrically connecting to one of the capacitor plates; and a plurality of via bars within the layers of dielectric material and interleaved with the plurality of capacitor plates, the plurality of via bars comprising a different width dimension than the plurality of capacitor plates. Additional features of the structure are set forth in dependent claims 2 to 9.

In an aspect of the disclosure, a structure comprises: a plurality of capacitor plates; a wiring structure electrically connecting to one of the capacitor plates; and a plurality of via bars interleaved with the plurality of capacitor plates, the plurality of via bars comprising a smaller width dimension than the plurality of capacitor plates. Additional features of the structure are set forth in dependent claims 11 to 14.

In an aspect of the disclosure, a method comprises: forming a capacitor structure comprising a plurality of capacitor plates within layers of dielectric material; forming a wiring structure in a lower layer of the dielectric material, the wiring structure electrically connecting to one of the capacitor plates; and forming a plurality of via bars within the layers of dielectric material and interleaved with the plurality of capacitor plates, the plurality of via bars comprising a different width dimension than the plurality of capacitor plates.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1A shows a cross-sectional view of a capacitor structure in accordance with aspects of the present disclosure.
FIG. 1B shows a top view of the capacitor structure of FIG. 1A in accordance with aspects of the present disclosure.
FIG. 2 shows a cross-sectional view of a capacitor structure in accordance with additional aspects of the present disclosure.
FIG. 3 shows a top view of a capacitor structure in accordance with further aspects of the present disclosure.
FIGS. 4A-4E show fabrication processes of manufacturing the capacitor structure of FIGS. 1A and 1B in accordance with aspects of the present disclosure.

### DETAILED DESCRIPTION

The present disclosure relates to semiconductor structures and, more particularly, to via bars interleaved between conductive plates of a capacitor structure and methods of manufacture. More specifically, the capacitors includes interleaved metal structures, e.g., via bars, between conductive plates of the capacitor. In embodiments, the via bars may be metal via bars which are located at a half-pitch between the conductive plates of the capacitor structure; although other spacing and dimensions are contemplated herein. Advantageously, the via bars placed between the conductive plates will enhance capacitance density and, hence, capacitance of the structure, without the need for additional processes.

The structures of the present disclosure can be manufactured in a number of ways using a number of different tools. In general, though, the methodologies and tools are used to form structures with dimensions in the micrometer and nanometer scale. The methodologies, i.e., technologies, employed to manufacture the structures of the present disclosure have been adopted from integrated circuit (IC) technology. For example, the structures are built on wafers and are realized in films of material patterned by photolithographic processes on the top of a wafer. In particular, the fabrication of the structures uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

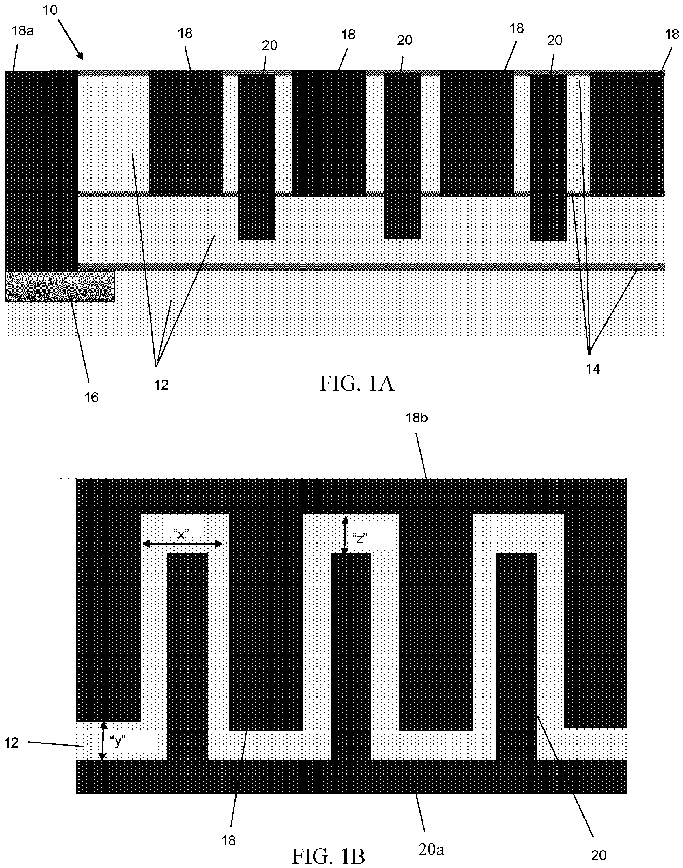

FIG. 1A shows a cross-sectional view of a capacitor structure in accordance with aspects of the present disclosure. FIG. 1B shows a top view of the capacitor structure of FIG. 1A. As shown in FIGS. 1A and 1B, the structure 10 includes a plurality of layers of dielectric material 12, 14. The dielectric material may be alternating layers of oxide material 12 and nitride material 14; although other layers of different dielectric materials may be contemplated herein including any front end or back end of the line interlevel dielectric materials.

Referring specifically to FIG. 1A, a metal wiring layer 16 may be provided in a lower dielectric material 12. In embodiments, the metal wiring layer 16 may be any metal wiring layer above a transistor or other active device, e.g., front end of the line device. In embodiments, the metal wiring layer 16 may be electrically connected to a front end of line device, e.g., transistor.

Referring to FIGS. 1A and 1B, a plurality of capacitor plates 18a, 18 may be provided in the layers of dielectric material 12, 14, with at least one capacitor plate 18a electrically and directly connected to the metal wiring layer 16. In embodiments, the capacitor plates 18a, 18 may be any conductive material including, for example, copper. Moreover, the capacitor plates 18a, 18 may be separated by the oxide material 12 and, as such, may form a metal-oxide-metal capacitor.

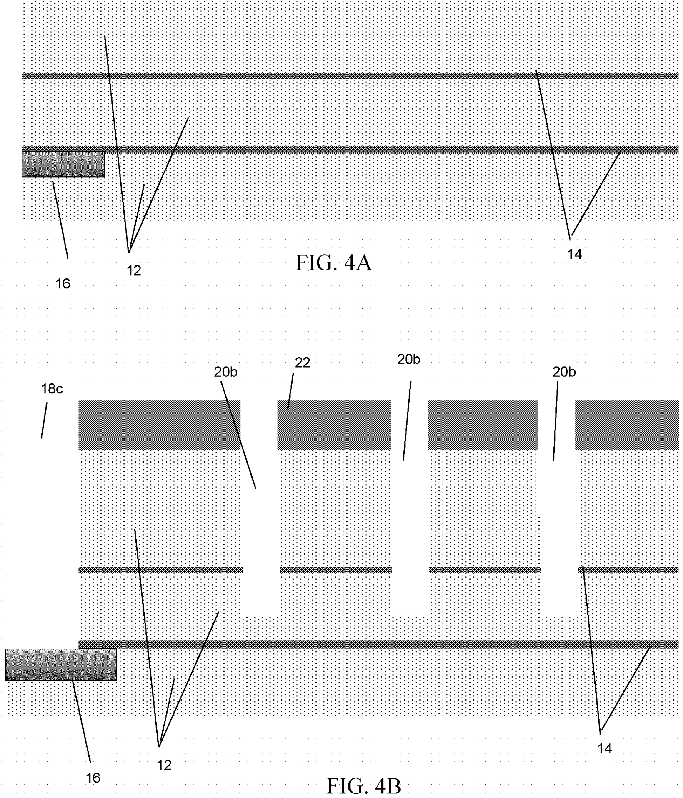

Via bars 20 may be interleaved with the capacitor plates 18a, 18, which effectively increases the density of the capacitor structure. The via bars 20 may be composed of a conductive material such as copper. In embodiments, the via bars 20 may be deeper than the capacitor plates 18, shallower than the capacitor plate 18a, and may be located at a half-pitch with respect to the spacing between adjacent capacitor plates 18a, 18. Also, in this embodiment, the via bars 20 will not extend to the underlying metal wiring layer 16. Also, in embodiments, the via bars 20 do not overlap with the capacitor plates 18, e.g., they are separate structures, as described in more detail with respect to FIGS. 4A-4E.

Referring to FIG. 1B, the plurality of capacitor plates 18a, 18 may be a comb structure with each of the capacitor plates 18a, 18 connected together by a common metal rail 18b. Similarly, the via bars 20 may be a comb structure connecting together by a common metal rail 20a. In embodiments, the via bars 20 are interleaved with the capacitor plates 18a, 18 and may be offset or located at a half-pitch with respect to the spacing of the capacitor plates 18a, 18; although other dimensions are contemplated herein. Accordingly, as should be understood by those of ordinary skill in the art, the via bars 20 reduce the spacing in between the capacitor plates 18a, 18 to enhance capacitor density.

Referring still to FIG. 1B, the width of the capacitor plates 18 (e.g., fat wires) may be a minimum fat wire width, e.g., 0.4 µm or less. The width of the common metal rail 18b may be greater than the minimum fat wire width. A distance "x" between the capacitor plates 18a, 18 may be, for example, a minimum metal spacing as further described below. A distance "y" between the ends of each capacitor plate 18 and the common metal rail 20a may be greater than a minimum metal spacing. Similarly, a distance "z" between ends of each via bars 20 and the common metal rail 18b may be greater than a minimum metal spacing.

By way of example, in embodiments, the via bars 20 have a width or diameter that is smaller than a width or diameter of the capacitor plates 18a, 18. For example, the width or diameter of the via bars 20 may be one-half or more of the width or diameter of the capacitor plates 18a, 18. In one exemplary embodiment, the width or diameter of the capacitor plates 18a, 18 may be about 0.4 µm with a spacing therebetween of about 0.4 µm; whereas the width or diameter of the via bars 20 may be 0.2 µm with a spacing between adjacent capacitor plates 18a, 18 of about 0.1 µm.

It should also be recognized that the above dimensions are provided for illustrative purposes and that other dimensions and spacing are also contemplated herein depending on the desired capacitor density. For example, the width or diameter of the via bars 20 may be 0.3 µm with a spacing between adjacent capacitor plates 18a, 18 of about 0.05 µm. In further embodiments, a spacing between each of the plurality of via bars 20 and adjacent capacitor plates 18 is less than the width dimension of the via bars 20. Accordingly, the placement of the via bars 20 between the capacitor plates 18a, 18 will effectively enhance capacitor density by decreasing the space between conductive structures.

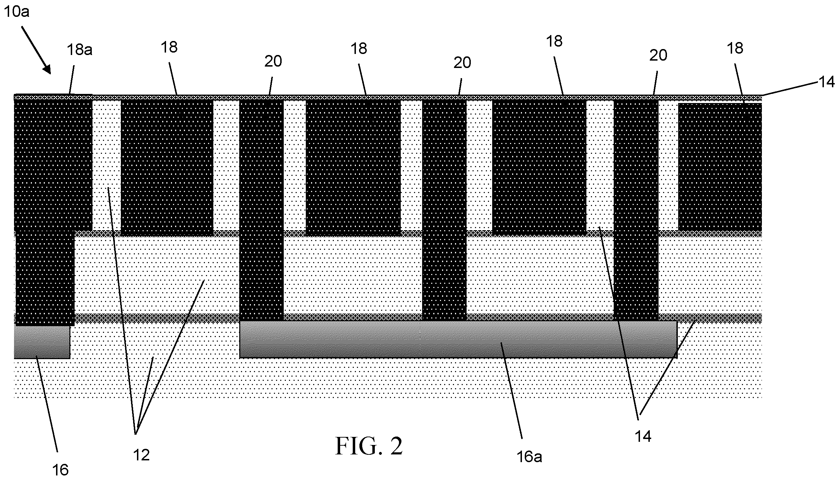

FIG. 2 shows a cross-sectional view of a capacitor structure in accordance with additional aspects of the present disclosure. In the structure 10a, the via bars 20 may extend to the underlying wiring layer 16a provided in a lower dielectric material 12. In embodiments, the metal wiring layer 16a may be any metal wiring layer above a transistor or other active device, e.g., front end of the line device. The remaining features of the structure 10a are similar to the structure 10 of FIGS. 1A and 1B.

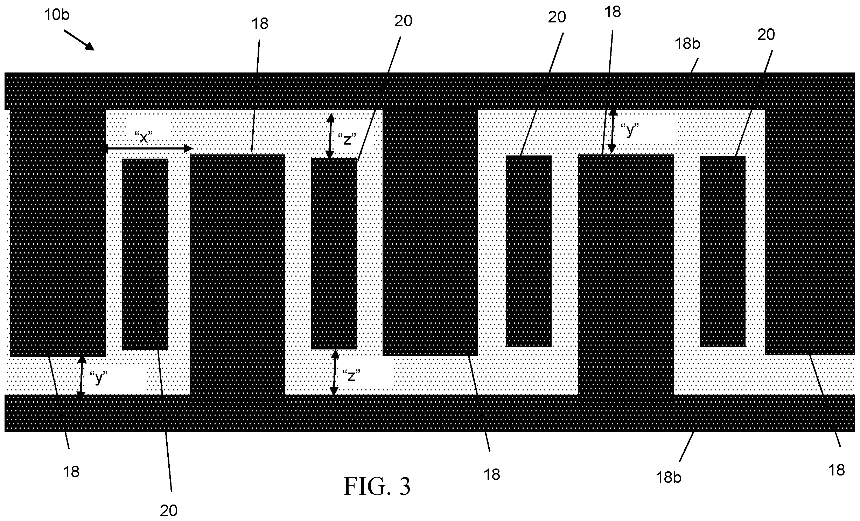

FIG. 3 shows a top view of a capacitor structure 10b in accordance with further aspects of the present disclosure. In the structure 10b, the capacitor includes upper and lower capacitor plates 18 provided in a comb structure. In this configuration, the capacitor plates 18 are interleaving from the top and bottom and the via bars 20 are floating between the upper and lower capacitor plates 18. Accordingly, in this embodiment, the via bars 20 are separate bars that are not connected to one another or to other structures. The remaining features of the structure 10a are similar to the structure 10 of FIGS. 1A and 1B.

As shown in FIG. 3, the width of the capacitor plates 18 (e.g., fat wires) may be a minimum fat wire width. The width of the common metal rail 18b may be greater than the minimum fat wire width. A distance "x" between the capacitor plates 18 may be, for example, a minimum metal spacing. A distance "y" between the ends of each capacitor plate 18 and the common metal rail 18b may be greater than a minimum metal spacing. Similarly, a distance "z" between ends of each via bars 20 and the common metal rail 18b may be greater than a minimum metal spacing.

FIGS. 4A-4E show fabrication processes of manufacturing the capacitor structure of FIGS. 1A and 1B. FIG. 4A shows the plurality of layers of dielectric material 12, 14 with the metal wiring layer 16 provided in a lower dielectric material 12. The dielectric material may be alternating layers of oxide material 12 and nitride material 14 deposited by conventional deposition methods, e.g., chemical vapor deposition (CVD) processes. The metal wiring layer 16 may be formed by conventional lithography, etching and deposition methods as is known in the art such that no further explanation is required for a complete understanding of the present disclosure.

In FIG. 4B, trenches 18c, 20b are formed through the plurality of layers of dielectric material 12, 14. In embodiments, the trench 18c may be used for the capacitor plate 18a and the trenches 20b may be used for the via bars 20. The trench 18c is preferably wider than the trenches 20b.

The trenches 18c, 20b can be formed by conventional lithography, etching and deposition methods known to those of skill in the art. For example, a resist 22 formed over the insulator material 12 is exposed to energy (light) and developed utilizing a conventional resist developer to form a pattern (openings). An etching process with a selective chemistry, e.g., reactive ion etching (RIE), will be used to transfer the pattern from the patterned photoresist layer to form the trenches 18c, 20b through the insulator materials 12, 14. In embodiments, the etch rate to form the trench 18c will be faster than the etch rate to form the trench 20b due to the wider dimension of the trench 18c. Accordingly, the trench 18c will be etched deeper into the insulator materials 12, 14 than the trenches 20b. In embodiments, the etching for the trench 18c will stop on the lower dielectric layer 14.

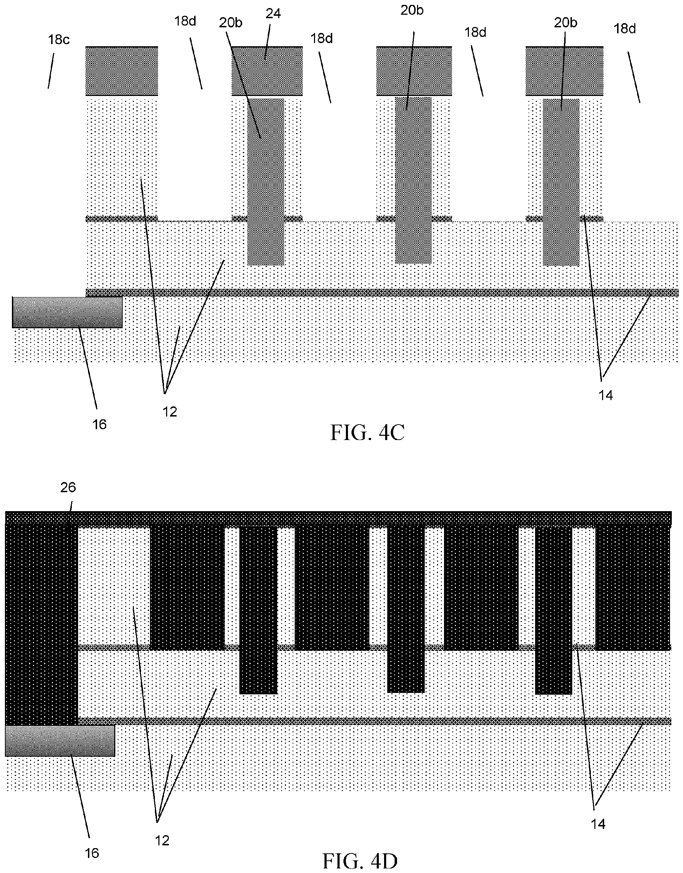

In FIG. 4C, the trenches 20b may be filled with resist material 24. The resist material 24 may also be formed (e.g., deposited) and patterned over the insulator material 12 using conventional deposition and lithography processes as are known to those of skill in the art such that no further explanation is required for a complete understanding of the present disclosure. In embodiments, the resist material 24 in the trenches 20b will prevent additional etching from occurring in the trenches 20b during the etching of trenches 18d used to form the capacitor plates 18. In this way, the pattern of the resist material 24 will coincide with the trenches 18d used to form the capacitor plates 18. By using the resist material 24 in the trenches 20b, the capacitor plates 18 formed in the trenches 18d will not overlap with the via bars 20 formed in the trenches 20b. Through conventional etching processes, e.g., RIE, the trenches 18d will be formed through the insulator materials 12, 14.

In FIG. 4D, following removal of the resist material 24 by a conventional oxygen ashing process or other known stripants, another etching process may be performed to remove the nitride layer 14 and expose the underlying metal wiring layer 16, which is performed through the trench 18c. Conductive material 26, e.g., copper, can be deposited in the trenches 18c, 18d, 20b by any conventional deposition processes, e.g., CVD processes. The deposition of the conductive material 26 may be used to form the capacitor plates 18a, 18 and via bars 20.

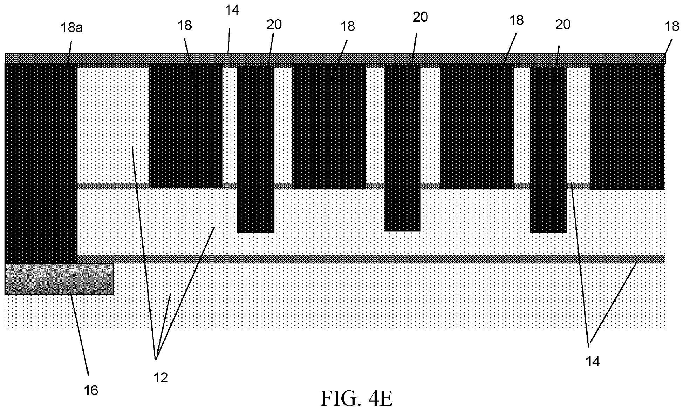

In FIG. 4E, any residual conductive material 26 on the surface of the insulator material 12 can be removed by conventional chemical mechanical polishing (CMP) processes. The insulator material 14, e.g., nitride material, may be deposited over the planarized structure. The insulator material 14 may be deposited by any conventional deposition process, e.g., CVD.

The structures can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multichip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
a capacitor structure comprising a plurality of capacitor plates within layers of dielectric material;
a wiring structure in a lower layer of the dielectric material, the wiring structure electrically connecting to one of the capacitor plates; and
a plurality of via bars within the layers of dielectric material and interleaved with the plurality of capacitor plates, the plurality of via bars comprising a different width dimension than the plurality of capacitor plates.

2. The structure of claim 1, wherein the capacitor plates comprise a comb structure.

3. The structure of claim 2, wherein the plurality of via bars comprise a comb structure interleaved within the capacitor plates.

4. The structure of claim 2 or claim 3, wherein the via bars connect to an underlying metal wiring layer in the lower layer of the dielectric material.

5. The structure of one of claims 1 to 4, wherein the plurality of capacitor plates are interleaved with one another.

6. The structure of claim 5, wherein the plurality of interleaved capacitor plates comprise a first comb structure interleaved with a second comb structure, and, optionally, wherein the first comb structure is a top comb structure and the second comb structure is a bottom comb structure.

7. The structure of claim 6, wherein the plurality of via bars are free floating via bars, and, optionally, wherein the free floating via bars are between the plurality of capacitor plates of the first comb structure and the second comb structure.

8. The structure of one of claims 1 to 7, wherein the plurality of via bars do not overlap with the plurality of capacitor plates.

9. The structure of one of claims 1 to 8, wherein the plurality of via bars have a smaller width dimension than the plurality of the capacitor plates, and/or wherein a spacing between each of the plurality of via bars and adjacent capacitor plates of the plurality of capacitor plates is less than the width dimension of the plurality of via bars.

10. A structure comprising:
a plurality of capacitor plates;
a wiring structure electrically connecting to one of the capacitor plates; and
a plurality of via bars interleaved with the plurality of capacitor plates, the plurality of via bars comprising a smaller width dimension than the plurality of capacitor plates.

11. The structure of claim 10, wherein the capacitor plates comprise a comb structure, and/or wherein the plurality of via bars comprise a comb structure interleaved within the capacitor plates.

12. The structure of claim 10 or claim 11, wherein the via bars connect to an underlying metal wiring layer in dielectric material.

13. The structure of one of claims 10 to 12, wherein the plurality of interleaved capacitor plates comprise a first comb structure interleaved with a second comb structure and the via bars are free floating between the interleaved capacitor plates of the first comb structure and the second comb structure.

14. The structure of one of claims 10 to 13, wherein the plurality of via bars do not overlap with the plurality of capacitor plates, and/or wherein a spacing between each of the plurality of via bars and adjacent capacitor plates of the plurality of capacitor plates is less than a width between the adjacent capacitor plates.

15. A method comprising:
forming a capacitor structure comprising a plurality of capacitor plates within layers of dielectric material;
forming a wiring structure in a lower layer of the dielectric material, the wiring structure electrically connecting to one of the capacitor plates; and
forming a plurality of via bars within the layers of dielectric material and interleaved with the plurality of capacitor plates, the plurality of via bars comprising a different width dimension than the plurality of capacitor plates.
